# EUROPEAN PATENT APPLICATION

(11) **EP 1 170 251 A1**
(43) Date of publication of application: **09.01.2002**
(21) Application number: 99933216.6
(22) Date of filing: 30.07.1999
(51) Int. Cl.: C01B 13/18, C01G 3/02, C01G 19/02, C01G 21/02, C01G 23/047, C01G 25/00, C01G 25/02, C01G 29/00, C01F 5/02, B01J 35/02

(54) **COMPOSITIONS FOR FORMING METAL OXIDE FILMS**

(30) Priority: 12.03.1999 JP 10987099; 12.03.1999 JP 10987199
(71) Applicant: Nagase Chemtex Corporation, Osaka 550-8668 (JP)
(72) Inventor: SATOH, Mitsunobu, Hachiohji-shi Tokyo 192-0363 (JP); NISHIDE, Toshikazu, Kohriyama-shi Fukushima 963-8871 (JP); OTSUKI, Tetsuya, c/o Nagase ChemteX Corporation, Itami-shi Hyogo 664-0898 (JP); SAKASHITA, Yoshiaki, c/0 Nagase ChemteX Corpor., Itami-shi Hyogo 664-0898 (JP); SUENAGA, Hitoshi, c/o Nagase ChemteX Corporation, Itami-shi, Hyogo 664-0898 (JP)
(74) Representative: MacLean, Martin Robert
(86) International application number: JP9904144
(87) International publication number: WO0055091

(57) **Abstract**

A composition for forming a metal oxide thin film containing a salt of an amine and a metal complex formed of a ligand having 5 or less coordination and a metal compound is provided.

Compared with a conventional compound containing a salt of an amine and a metal complex formed of a ligand having 6 or more coordination and a metal compound, the present invention can contain metal oxide in a high concentration. The metal oxide can be contained in a high concentration, so that a comparatively thick and uniform film can be formed in one film-forming process. Therefore, the present invention is advantageous in terms of production process, and the cost to transport the composition for thin films can be reduced significantly.

Furthermore, the ligand having 5 or less coordination used in the present invention has excellent biodegradability, so that environmental pollution can be reduced in the production process.

## Description

### Technical Field

The present invention relates to compositions for forming metal oxide thin films. More specifically, the present invention relates to compositions used to form metal oxide thin films that are formed by applying the compositions onto substrates made of glass, metal, ceramics or the like and baking the compositions, and methods for producing the same.

### Background Art

Metal oxide thin films are used as conductors, photocatalysts or the like. As a method for forming a metal oxide thin film on a surface of glass, metals, ceramics, etc., dry methods such as sputtering, CVD (chemical vapor deposition), PVD (physical vapor deposition) and wet methods such as the sol-gel method, plating, and electrolytic polymerization have been conventionally known. With sputtering, which is a typical dry method, uniform and stable thin films can be obtained, but the apparatus for this method is complicated and expensive, thus leading to a high production cost. Moreover, there are constraints such as difficulties in achieving large area thin films.

The sol-gel method, which is a typical wet method, provides a metal oxide thin film by adding water and a catalyst to a metalalkoxide dissolved in an organic solvent to cause hydrolysis condensation polymerization to form a sol, applying the sol to a substrate and baking the sol.

The sol-gel method is described in detail in "Chemical Science of Sol-gel method", 1988, pages 85-103 (published by Agune Syofu Sya). Although the apparatus for this sol-gel method is simple and large area thin films can be formed, this method requires strict control of the conditions for formation of thin films to constantly ensure uniform and homogenous metal oxide films, and there are other problems in practice to be solved, such as suppression of chemical changes of the sol.

The metal oxide thin films are used not only alone, but also often used as a composite film with other metal oxides in practice. In the sol-gel method, since the hydrolysis rate of metalalkoxide significantly varies depending on the type of the metal, it is generally difficult to obtain a cocondensation polymer having a uniform composition by mixing two or more types of metalalkoxides and hydrolyzing the mixture. Also when mixing two or more sol liquids separately obtained by hydrolysis condensation polymerization of metalalkoxide, since the hydrolysis condensation polymerization rate of the metalalkoxide significantly depends on the metal type, the hydrolysis condensation polymerization of one metal alkoxide proceeds faster than the others. As a result, since sol or metal oxide precipitates, there are the problems that the stability of the solution cannot be maintained or the uniformity is lost, among others.

In order to solve these problems, Japanese Laid-Open Patent Publication (Tokkai) No. 9-278489 proposes a composition for forming metal oxide thin films containing a salt of a metal complex and alkylamine. In a coating solution obtained from a single metal, the reaction is completed, and the reaction no longer proceeds, so that such a coating solution is very stable. Furthermore, two or more types of metal are mixed in a desired ratio and stably contained in the composition. Moreover, compositions of two or more metal types are prepared, and a composition obtained by mixing these compositions in an arbitrary ratio forms a uniform solution. Thus, the composition for forming a metal oxide thin film described in Japanese Laid-Open Patent Publication (Tokkai) No. 9-278489 is an excellent composition.

On the other hand, all the ligands used in the method described in Japanese Laid-Open Patent Publication (Tokkai) No. 9-278489 have at least six coordination. These ligands having at least six coordination form a significantly stable complex with metal. However, the composition has a problem in that it is difficult to contain a high concentration of metal compound in the composition. For example, a salt of a titanium complex of ethylenediaminetetraacetic acid and low molecular weight amines such as ethylamine, diethylamine, propylamine, and diisopropylamine is dissolved in water, methanol, ethanol or the like. However, for example, a composition obtained by dissolving this salt in a concentration of 2% as the content of titanium compound in terms of titanium oxide in ethanol has a problem in that storage for a long period causes crystal precipitation. Another problem is that this composition is difficult to dissolve in isopropanol, n-butanol or the like. Thus, it is disadvantageous of titanium compound in terms of transportation cost in actual use that only a composition having a low metal oxide content can be stable when it is produced. Furthermore, there are problems such as limitations in designing the composition when other components are combined.

In order to improve these disadvantages, approaches such as using amines having a comparatively long carbon chain such as di-n-butylamine and di-n-pentylamine, or using aromatic amines and aliphatic amines together may be effective, but there still remain limitations regarding the selection of solvents and amines.

Furthermore, among the ligands described in Japanese Laid-Open Patent Publication (Tokkai) No. 9-278489, ethylenediaminetetraacetic acid and diethylenetriaminepentaacetic acid, which are widely used and inexpensive, have no biodegradability. It seems that the other ligands described in this publication also cannot be expected to have biodegradability in light of their symmetrical structure. Therefore, it is also desired to use ligands having excellent biodegradability to prevent environmental pollution in the production process of metal oxide thin films.

Therefore, there is a demand for a composition for forming a metal oxide thin film in which no crystal precipitates even if a metal complex is contained in a high concentration and that has excellent biodegradability is.

### Disclosure of the Invention

The inventors of the present invention conducted research on a wide range of types of ligands to solve the above problems, and found that a composition containing a salt of an amine and a metal complex or a salt of a metal compound obtained by reacting a ligand having 5 or less coordination with a metal compound can solve the above problems, and thus attained the present invention.

The present invention relates to a composition for forming a metal oxide thin film comprising a salt of an amine and a metal complex or a salt of a metal compound formed of a ligand having 5 or less coordination and a metal compound.

In a preferable embodiment, ionic dioxide are coordinated in the metal.

In another preferable embodiment, the salt is dissolved in a polar solvent.

In a preferable embodiment, the ligand having 5 or less coordination is an amino polycarboxylic acid, a hydroxycarboxylic acid or an amino acid.

In another preferable embodiment, the amine is an aliphatic amine or an aromatic amine having 12 or less carbon atoms.

In a preferable embodiment, the salt of an amine and a metal complex or a metal salt is a salt of an amine and a complex or a salt of titanium, bismuth, barium, zirconium, magnesium, lead, copper, tin, zinc, indium, or strontium, or a combination of two or more of these.

In a further preferable embodiment, the composition for forming a metal oxide thin film is a composition for a composite metal oxide comprising titanium, and contains a salt of a titanium complex and an amine and a salt of other metal complex and an amine.

In a more preferable embodiment, the composition for forming a metal oxide thin film is a composition for bismuth titanate composite metal oxide, and contains a salt of a titanium complex and an amine and a salt of a bismuth complex and an amine.

In a more preferable embodiment, the composition for forming a metal oxide thin film is a composition for barium titanate composite metal oxide, and contains a salt of a titanium complex and an amine and a salt of a barium salt and an amine.

In another preferable embodiment, the composition for forming a metal oxide thin film is a composition for lead zirconate titanate composite metal oxide, and contains a salt of a titanium complex and an amine, a salt of a zirconium complex and an amine, and a salt of a lead salt and an amine.

The present invention also relates to a method for producing a composition for forming a metal oxide thin film including the step of reacting a metal compound, a ligand having 5 or less coordination, and an amine.

In a preferable embodiment, the method further includes the step of treating with an oxidizer after the above step.

In a more preferable embodiment, the metal compound is metal alkoxide.

### Brief Description of the Drawings

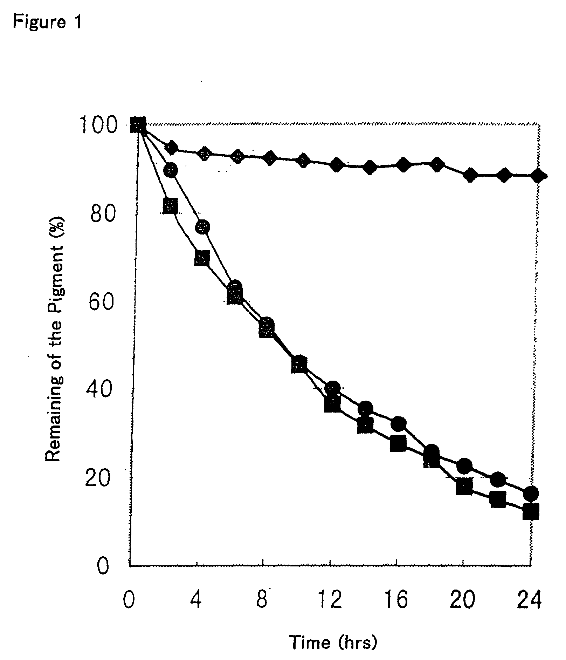

Figure 1 is a graph showing that a thin film containing titanium oxide obtained from a composition of the present invention has the same dye degradation activity as that of a thin film obtained by a conventional method. In Figure 1, ◆ indicates a blank, ■ indicates a titanium containing thin film prepared in Example 19, and ● indicates a thin film produced with titania sol.

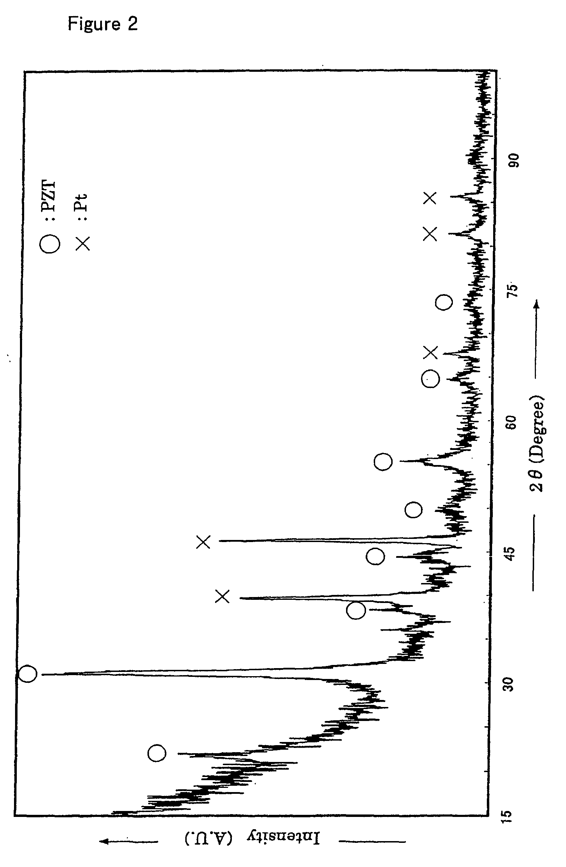

Figure 2 shows the results of X-ray diffraction measurement at room temperature of lead zirconate titanate baked at 700°C in the atmosphere. In Figure 2, ○ indicates the peaks of a perovskite structure, and indicates the peaks derived from platinum used as a substrate.

### Beat Mode for Carrying Out the Invention

Examples of ligands having 5 or less coordination used for preparing a composition of the present invention include acids such as amino polycarboxylic acids, hydroxycarboxylic acids and amino acids, and salts of these acids.

Examples of amino polycarboxylic acids include nitrilotriacetic acids, nitrilotripropionic acids, carboxyethyl iminodiacetic acids, carboxymethyliminodipropionic acids, iminodiacetic acids, iminodipropionic acids, hydroxyethyliminodiacetic acids, hydroxyethyl iminodipropionic acids, methoxyethyliminoacetic acids, alanine-N,N-diacetic acids, serine-N,N-diacetic acids, isoserine-N,N-diacetic acids, aspartic acid-N,N-diacetic acids, glutamic acid-N,N-diacetic acids, and salts thereof.

Examples of hydroxycarboxylic acids include glycolic acids, lactic acids, malic acids, tartaric acids, citric acids, and salts thereof.

Examples of amino acids include alanine, β-alanine, glycine, serine, isoserine, aspartic acid, glutamic acid, sarcosine, leucine, isoleucine and salts thereof.

The above-listed amino polycarboxylic acids, hydroxycarboxylic acids and amino acids are shown as examples, and the present invention is not limited thereto.

Examples of metal types used to prepare the composition of the present invention include, without limitation, Ti, Zr, Hf, Mg, Ca, Sr, Li, Ba, Y, La, Al, Ga, In, Ge, Sn, Pb, Sb, Bi, Fe, Co, Ni, Cu, Zn, Ag, V, Nb, Pd, Ta, Mo, and W.

Examples of metal compounds used to prepare the composition of the present invention include metalalkoxide, metal chloride, metal sulfate, metal nitrate and organic acid metal salts. Among these, metalalkoxide is preferable. When metalalkoxide is used as the starting material, the production process can be simplified. In other words, a composition can be obtained in one pot by reacting metalalkoxide, a ligand, and amines in a solvent. The production method using metalalkoxide as the starting material is particularly excellent in view of the fact that the conventional method includes a two stage-reaction, i.e., first isolating a metal complex or a metal salt and then reacting it with amines.

In order to prepare a metal complex or a metal salt with a metal compound and a ligand having five or less coordination, a ligand (e.g., an amino polycarboxylic acid or a salt thereof) is suspended or dissolved in water or a solvent, and a metal compound or a solution of a metal compound is added thereto. Alternatively, a powder, a solution or a suspension of a ligand can be added to a solution of a metal compound.

In the case of titanium chloride, heating is performed, if necessary, and a reaction is caused while introducing air into a reaction solution during stirring to promote oxidation, and then the complex is collected in the form of crystal. This crystal is washed with water and dried, and thus can be used as a raw material of the composition of the present invention. When the reaction is carried out without introducing air to the reaction solution, the complex is hardly formed, and only a crystal containing a large amount of unreacted aminopolycarboxylic acid can be obtained.

Furthermore, a titanium complex used in the present invention can be obtained easily also by heating and stirring a suspension or a solution of a ligand (e.g., an amino polycarboxylic acid or a salt thereof) with an aqueous solution of a titanium sulfate in an inert gas. In this case, causing a reaction under oxidation conditions is not preferable because a large amount of undissolved material remains when preparing the composition.

When using metalalkoxide as the starting material, a ligand (e.g., an aminopolycarboxylic acid or a salt thereof) is suspended or dissolved in a polar solvent, then metalalkoxide is added and reacted therewith, and thus a metal complex can be obtained. As described below, this metal complex can be used without being isolated to produce a composition of the present invention, which is the most efficient method.

There is no particular limitation regarding the amines that form a salt with a metal complex or a metal salt formed of a ligand having 5 or less coordination and a metal compound, but aliphatic amines and aromatic amines are preferable.

Examples of aliphatic amines include primary or secondary amines with an alkyl group having 12 or less carbon atoms. For an alkyl group having more than 12 carbon atoms, there is too much organic component, and thus it tends to be difficult to obtain dense films.

Examples of such amines include, without limitation, ethylamine, diethylamine, n-butylamine, di-n-butylamine, di-sec-butylamine, di-terbutylamine, n-propylamine, di-n-propylamine, amylamine, diamylamine, isopropylamine, diisopropylamine, isobutylamine, diisobutylamine, isoamylamine, diisoamylamine, ethyl-n-butylamine, ethyl-n-propylamine, ethylisopropylamine, isopropyl-n-butylamine, di-n-pentylamine, n-hexylamine, dihexylamine, and n-octylamine.

Examples of aromatic amines include, without limitation, pyridine derivatives such as pyridine, 4-methylpyridine, 4-aminopyridine and 4-dimethylaminopyridine, benzylamine derivatives such as benzylamine, N,N-dimethylbenzylamine, and aniline derivatives such as N,N-dimethylaniline and N,N-dimethyl-p-toluidine.

These amines can be used alone or in combination of two or more. The solubility of an amine salt of a metal complex or a metal salt in the polar solvent may depend on the type of the amine used. Therefore, selection of a combination of a polar solvent and an amine is also important. Those skilled in the art can select a combination as appropriate. It is preferable to use a mixture of, for example, a linear diamine and a branched diamine, for example, in equal amounts or with a larger amount of the branched diamine.

A salt of the obtained metal complex or metal salt and amine can be obtained by mixing the metal complex or the metal salt with amines in a solvent. As a result, the composition of the present invention can be obtained.

When a metalalkoxide is used as the starting material, without isolating the metal complex or a metal salt formed in the solvent, amines are added to the solvent to form a salt with the metal complex or the metal salt, and thus the composition of the present invention can be obtained.

The composition of the present invention includes the thus obtained salt of the metal complex or the metal salt and the amine. Furthermore, it is preferable that ionic dioxide is coordinated in the metal in view of the stability of the solution. The metal may be treated with an oxidizer in order to coordinate ionic dioxide in the metal.

Examples of oxidizers include, without limitation, hydrogen peroxide, perchloric acid, ozone, lead oxide, and barium peroxide.

The oxidizer can be added thereto at the same time as other raw materials or after a salt of a metal complex or a metal salt and an amine is formed.

There is no limitation regarding solvents used for the composition of the present invention, but polar solvents are preferable. Examples of polar solvents include lower alcohols such as methanol, ethanol, isopropanol, n-propanol, n-butanol, isobutanol and t-butanol. If necessary, other solvents (e.g., water, aceton etc.) that can be admixed with lower alcohols can be mixed therewith.

The composition of the present invention can include water, which indicates the advantage that the mixture stability of the composition of the present invention is excellent and causes no precipitation or the like, even if a substance containing water is added thereto. Furthermore, moisture in the air causes no adverse effect while the composition of the present invention is being applied and dried. Therefore, the property of being stable even if a water is contained is very advantageous in actual use.

Moreover, because the composition of the present invention is applied onto a substrate and dried to form a metal oxide thin film, a solvent having a boiling point as low as possible is preferable.

With the above-described method, the composition for forming a metal oxide thin film of the present invention can be obtained.

In the composition of the present invention, taking titanium as an example, containing titanium in a concentration up to about 8.0wt% of metal oxide causes no crystal precipitation. The composition of the present invention can contain a much higher concentration of metal oxide, compared with a conventional composition using a ligand having 6 or more coordination. In the conventional composition, crystal precipitation occurs when the composition contains titanium in a concentration of about 2wt%. In the case of lead, crystal precipitation occurs at a concentration of about 9.4wt%. However, when ethylenediaminetetraacetic acid with 6 coordination is used, no dissolution occurs at this concentration.

The composition of the present invention is much more excellent than a composition using a ligand having 6 or more coordination, because it can contain metal in a high concentration of metal compound in terms of metal oxide.

Furthermore, the composition of the present invention has biodegradability, in contrast with conventionally used ligands having 6 or more coordination, such as ethylenediaminetetraacetic acid and diethylenetriaminepentaacetic acid, which have no biodegradability. Therefore, the present invention is also useful to prevent environmental pollution in the production process of metal oxide thin films.

The composition of the present invention may include a salt of a single metal complex and an amine or a salt of 2 or more metal complexes or metal salts and an amine. The composition including a salt of 2 or more metal complexes or metal salts and an amine is used as a composition for forming a composite metal oxide thin film. Such a composition can be obtained by mixing metal compounds to form a composite metal complex or metal salt, and then forming a salt of an amine and the composite metal complex or metal salt in a solvent. Alternatively, such a composition can be obtained by preparing compositions including salts of different metal types and an amine, and mixing the compositions. There is no particular limitation regarding the mixing ratio of the salt. Those skilled in the art can determine it as appropriate, in view of the application and the like.

The application of the composition for forming a metal oxide thin film of the present invention is determined depending on the metal included therein.

The thin films made of a composition for forming a metal oxide thin film containing titanium or strontium titanate are used to form photocatalyst thin films. In particular, titanium oxide thin films are useful as photocatalysts.

Furthermore, thin films formed of the compositions for forming composite metal oxide thin films including titanium and other metal can be ferroelectric, and can be used to produce storage devices or be used as transducers using piezoelectricity. In order to be ferroelectric material, the metal oxide is required to have a perovskite structure. The composite metal oxides of titanium and other metals are preferable as ferroelectric, because they, in particular, easily take on a perovskite structure. Examples of the metals that can be combined with titanium include bismuth, barium, zirconium, lead, and strontium. Among these, a combination of titanium and bismuth, titanium and barium, titanium and lead or titanium, zirconium and lead is preferably used.

Furthermore, thin films formed of compositions for forming metal oxide thin films including indium, tin, zinc, antimony and combinations of these metals are used as conductive material. Among these, a thin film including indium alone or a combination of indium and tin or tin and antimony can be used as conductive material.

Furthermore, thin films formed of compositions for forming thin films including iron oxide can be used as magnetic films.

The composition of the present invention is applied onto the substrate, dried and baked to provide a metal oxide thin film. The composition of the present invention may be used as a coating solution as it is. When the concentration of the composition is too high to be used as a coating solution, the composition is diluted with an appropriate solvent to provide a suitable solution. The solvent used for dilution may be the same solvent as used for the composition or may be another solvent.

Examples of the substrate onto which the composition of the present invention or the coating solution is applied include glass substrates such as quartz glass, soda-lime glass and borosilicate glass, metal plates such as SUS, copper and aluminum, and ceramic substrates such as alumina, silica and zirconia.

The composition of the present invention or the coating solution can be applied onto a substrate by an appropriate method as used by those skilled in the art. For example, any of spinning, dipping and flow expanding can be used, and uniform and stable coated films can be formed with a simple apparatus. The coated films before baking can be removed easily with a solvent (e.g., water, alcohol). Therefore, the yield in the production of the coated films can be very high, because re-coating can be performed.

Metal oxide thin films can be obtained by drying the coated films to volatilize the solvent and baking the coated films at a temperature equal to or higher than the temperature at which organic compounds can be baked. The baking temperature may be determined as appropriate in accordance with the application of the thin film. Generally, the baking temperature is from 400°C to 800°C, preferably from 500°C to 700°C or from 550°C to 650°C. It is also effective to perform preliminary baking (pre-baking) at a comparatively low temperature, if necessary, for achieving uniform thin films. Baking may be performed by a method such as increasing temperature from room temperature to a predetermined temperature, baking in several stages at different baking temperatures or placing the substrates coated with the composition of the present invention into a furnace in which a predetermined temperature is set.

The thus obtained metal oxide thin films or composite metal oxide thin films have properties equal to those of thin films obtained by a sol-gel method or the like.

The obtained (composite) metal oxide thin films are used in various applications in accordance with the type of the contained metal. For example, when the metal oxide has a perovskite structure, the (composite) metal oxide thin film is used as a ferroelectric substance. The thin films formed of titanium oxide, bismuth titanate, barium titanate, lead zirconate titanate, which are composite metal oxides, etc. can take on a perovskite structure, are ferroelectric, and can be used to produce storage devices or be used as transducers utilizing piezoelectricity. Furthermore, thin films containing titanium oxide are used as photocatalyst films, and thin films containing iron oxide are used as magnetic films.

Hereinafter, the present invention will be described by way of examples. However, the present invention is not limited thereto.

### Example 1

First, 13.7g of dehydrated ethanol and 10.32g of nitrilotriacetic acid were fed into a 100ml four-necked flask, and 15.35g of titanium tetraisopropoxide were added dropwise under stirring. Then, 7.76g of di-n-butylamine were added and reacted therewith at a reflux temperature for one hour, and thus a pale yellow transparent liquid was obtained. The liquid was cooled to 30°C, and 6.8g of 30% hydrogen peroxide solution were dripped thereto. After one hour reflux, the mixture was cooled, and thus a yellow transparent composition (solution) of the present invention was obtained. The content of titanium compounds in terms of titanium oxide was 8.0%. After three months storage of this composition at room temperature, crystal precipitation or the like was not observed, and the composition was still a transparent liquid.

### Example 2

First, 13.7g of dehydrated ethanol and 10.32g of nitrilotriacetic acid were fed into a 100ml four-necked flask, and 15.35g of titanium tetraisopropoxide were dripped under stirring. Then, 7.32g of n-butylamine were dripped and reacted therewith at a reflux temperature for one hour, and thus a pale yellow transparent liquid was obtained. The liquid was cooled to 30°C, and 6.8g of 30% hydrogen peroxide solution were dripped thereto. After one hour reflux, the mixture was cooled, and thus a yellow transparent composition (solution) of the present invention was obtained. The content of titanium compound in terms of titanium oxide was 8.0%.

### Example 3

First, 40.6g of dehydrated ethanol and 6.88g of nitrilotriacetic acid were fed into a 100ml four-necked flask, and 10.23g of titanium tetraisopropoxide were dripped under stirring. Then, 9.66g of dioctylamine were dripped and reacted therewith at a reflux temperature for one hour, and thus a colorless transparent composition (solution) of the present invention was obtained. The content of titanium compound in terms of titanium oxide was 4.3%.

### Example 4

First, 2.27g of 30% hydrogen peroxide solution were dripped into 34g of the solution obtained in Example 3. As dripping proceeded, the mixture turned from a colorless liquid to a pale yellow transparent liquid (a composition of the present invention). After one hour reflux, the liquid was cooled. The content of titanium compound in terms of titanium oxide was 4.0%. After four weeks storage of this solution at room temperature, crystal precipitation or the like was not observed.

### Example 5

First, 47.2g of dehydrated ethanol and 4.79g of D,L-aspartic acid were fed into a 100ml four-necked flask, and 10.23g of titanium tetraisopropoxide were dripped under stirring. Then, 5.17g of di-n-butylamine were dripped and reacted therewith at a reflux temperature for one hour, and thus a pale yellow transparent liquid (a composition of the present invention) was obtained. The content of titanium compound in terms of titanium oxide was 4.3%.

### Example 6

First, 2.15g of 30% hydrogen peroxide solution were added to 35.34g of the liquid obtained in Example 5. The liquid turned from colorless to dark tangerine. After one hour heating at a reflux temperature, the liquid was cooled. The content of titanium compound in terms of titanium oxide was 4.0%.

### Example 7

First, 94.36g of dehydrated ethanol and 9.68g of iminodiacetic acid were fed into a 200ml four-necked flask, and 20.47g of titanium tetraisopropoxide were dripped under stirring. Then, 10.34g of di-n-butylamine were dripped and reacted therewith at a reflux temperature for one hour. Then, the mixture was cooled to 50°C, and 9.07g of 30% hydrogen peroxide solution were dripped thereto. After one hour reflux at a reflux temperature, the mixture was cooled, and thus a golden yellow transparent liquid (a composition of the present invention) was obtained. The content of titanium compound in terms of titanium oxide was 4.0%.

### Example 8

First, 30g of dehydrated ethanol and 3.46g of citric acid were fed into 100ml four-necked flask, and 5.12g of titanium tetraisopropoxide were dripped under stirring. Then, 2.59g of di-n-butylamine were dripped and reacted therewith at a reflux temperature for one hour, and thus a pale yellow transparent liquid (a composition of the present invention) was obtained. The content of titanium compound in terms of titanium oxide was 3.5%.

### Example 9

First, 20g of dehydrated ethanol and 4.48g of aspartic acid-N,N-diacetic acid were fed into 100ml four-necked flask, and 5.12g of titanium tetraisopropoxide were dripped under stirring. Then, 4.65g of di-n-butylamine were dripped and reacted therewith at a reflux temperature for one hour, and thus a pale yellow transparent liquid (a composition of the present invention) was obtained. The content of titanium compound in terms of titanium oxide was 4.2%.

### Examples 10 to 18

The compositions of the present invention obtained in Examples 1 to 9 were diluted with dehydrated ethanol so that the content of titanium compound in terms of titanium oxide was 1.2% to provide coating solutions. Each coating solution was applied onto a 5cm × 5cm soda-lime glass by spin-coating at 600rpm and was dried with air. Then, pre-baking was performed at 100°C for ten minutes, followed by 30 minutes baking at 550°C. All the compositions provided slightly rainbow colored transparent thin films having a thickness of about 100nm. Each thin film was spin-coated with an ethanol solution of oleic acid in a concentration of 1% at 1000rpm and dried with air. Then, using black light (at a power of 15W), these thin films were irradiated with ultraviolet rays for two hours from a distance of 25cm. After irradiation, when water was allowed to flow slowly on the surface of the thin film, the water spread over the entire surface of the thin film. In other words, it turned out that the oleic acid layer had been degraded by the photocatalytic property of titanium oxide.

### Example 19

The composition of the present invention (a yellow transparent solution) obtained in Example 2 was diluted with ethanol so that the content of titanium compound in terms of titanium oxide was 4%. This coating solution was applied onto a 5cm × 5cm non-alkali glass by spin-coating at 1,000rpm. After pre-baking at 100°C for ten minutes, baking was performed at 550°C for 30 minutes, and thus a transparent titanium oxide thin film was produced. The obtained titanium oxide thin film was subjected to a dye degradation test. In other words, the titanium oxide thin film was placed in a laboratory dish containing a 5ppm methylene blue aqueous solution and the laboratory dish was irradiated with black light having an ultraviolet intensity of 2mW/cm². Then, changes in the absorbance of the methylene blue aqueous solution over time were measured with a spectrophotometer to measure the dye degradation capacity of the thin film. For comparison, titania sol synthesized by a sol-gel method was used.

Figure 1 shows the results. The results of Figure 1 indicate that the thin film formed of the composition of the present invention has substantially the same dye degradation activity as that of titania sol synthesized by a sol-gel method.

### Example 20

First, 40g of dehydrated ethanol and 3.44g of nitrilotriacetic acid were fed into a 100ml four-necked flask, and 7.85g of zirconiumtetra-n-butoxide (a purity of 88%) were dripped under stirring. Then, 2.59g of di-n-butylamine were dripped and reacted therewith at a reflux temperature for one hour, and thus a pale yellow transparent liquid (a composition of the present invention) was obtained. The content of zirconium compound in terms of zirconium oxide was 4.1%.

### Example 21

The solution of the composition of the present invention obtained in Example 20 was cooled to room temperature. First, 1.25g of 30% hydrogen peroxide solution were dripped to 30g of this solution. Then, after one hour reflux at a reflux temperature, the mixture was cooled, and thus a yellow transparent liquid (a composition of the present invention) was obtained. The content of zirconium compound in terms of zirconium oxide was 3.9%.

### Example 22

First, 40g of dehydrated ethanol and 3.46g of citric acid were fed into a 100ml four-necked flask, and 7.85g of zirconiumtetra-n-butoxide (a purity of 88%) were dripped under stirring. Then, 2.59g of di-n-butylamine were dripped and reacted therewith at a reflux temperature for one hour, and thus a pale yellow transparent liquid (a composition of the present invention) was obtained. The content of zirconium compound in terms of zirconium oxide was 4.1%.

### Example 23

First, 1.25g of 30% hydrogen peroxide solution were added to 34.7g of the solution of the composition of the present invention obtained in Example 22. Then, after one hour stirring at a reflux temperature, the mixture was cooled, and thus a pale yellow transparent liquid (a composition of the present invention) was obtained. The content of zirconium compound in terms of zirconium oxide was 3.9%.

### Example 24

First, 44g of dehydrated ethanol and 6.38g of hydroxyethyl iminodiacetic acid were fed into a 100ml four-necked flask, and 15.7g of zirconiumtetra-n-butoxide (a purity of 88%) were dripped under stirring. Then, 5.12g of n-butylamine were dripped and reacted therewith at a reflux temperature for one hour, and thus a pale yellow transparent liquid (a composition of the present invention) was obtained. The content of zirconium compound in terms of zirconium oxide was 6.5%.

### Example 25

First, 2.27g of 30% hydrogen peroxide solution were added to 38.15g of the solution of the composition of the present invention obtained in Example 24. After one hour stirring at a reflux temperature, the mixture was cooled, and thus a yellow transparent liquid (a composition of the present invention) was obtained. The content of zirconium compound in terms of zirconium oxide was 6.2%.

### Example 26

First, 42g of dehydrated ethanol and 6.38g of hydroxyethyl iminodiacetic acid were fed into a 100ml four-necked flask, and 15.7g of zirconiumtetra-n-butoxide (a purity of 88%) were dripped under stirring. Then, 2.59g of di-n-butylamine were dripped and reacted therewith at a reflux temperature for one hour, and thus a pale yellow transparent liquid (a composition of the present invention) was obtained. The content of zirconium compound in terms of zirconium oxide was 6.7%.

### Example 27

First, 2.27g of 30% hydrogen peroxide solution were added to 37.04g of the solution of the composition of the present invention obtained in Example 26. After one hour stirring at a reflux temperature, the mixture was cooled, and thus a yellow transparent liquid (a composition of the present invention) was obtained. The content of zirconium compound in terms of zirconium oxide was 6.3%.

### Example 28

First, 43.7g of dehydrated ethanol and 4.79g of D,L-aspartic acid were fed into a 100ml four-necked flask, and 15.7g of zirconiumtetra-n-butoxide (a purity of 88%) were dripped under stirring. Then, 5.17g of di-n-butylamine were dripped and reacted therewith at a reflux temperature for one hour, and thus a pale yellow transparent liquid (a composition of the present invention) was obtained. The content of zirconium compound in terms of zirconium oxide was 6.4%.

### Example 29

First, 2.10g of 30% hydrogen peroxide solution were added to 38.5g of the solution of the composition of the present invention obtained in Example 28. Then, after one hour stirring at a reflux temperature, the mixture was cooled, and thus an orange transparent liquid (a composition of the present invention) was obtained. The content of zirconium compound in terms of zirconium oxide was 6.1%.

### Examples 30 to 39

The compositions of the present invention obtained in Examples 20 to 29 were diluted with dehydrated ethanol so that the content of zirconium compound in terms of zirconium oxide was 2% to provide coating solutions. Each coating solution was applied onto a 5cm × 5cm soda-lime glass by spin-coating at 1000rpm, dried with air, and pre-baked at 100°C for ten minutes, followed by 30 minutes baking at 550°C. All the compositions provided transparent thin films having a thickness of about 100nm.

### Example 40

First, 45g of dehydrated ethanol and 6.88g of nitrilotriacetic acid were fed into a 100ml four-necked flask. While stirring, 4.12g of magnesium diethoxide were added, and 5.17g of di-n-butylamine were dripped thereto. The mixture was warmed and reacted for three hours at a reflux temperature, and thus a pale golden yellow transparent liquid (a composition of the present invention) was obtained. The content of magnesium compound in terms of magnesium oxide was 2.4%. This undiluted solution was applied onto a 5cm × 5cm borosilicate glass by spin-coating at 1000rpm and was dried. After 20 minutes pre-baking at 100°C, the borosilicate glass was placed in a high temperature furnace at 600°C and baked for 30 minutes, and thus a transparent thin film having a thickness of about 100nm was obtained.

### Example 41

First, 3.9g of nitrilotriacetic acid and 5.1g of lead acetate trihydrate were dispersed in 20g of ethanol in a 50ml conical flask. Then, 5.17g of di-n-butylamine were added thereto. The mixture was heated and stirred at about 80°C for three hours, and thus a colorless transparent liquid (a composition of the present invention) was obtained. The content of lead compound in terms of lead oxide was 9.4%. The obtained colorless transparent liquid was diluted with dehydrated ethanol so that the content of lead compound in terms of lead oxide was 2%. The diluted liquid was applied onto a 5cm × 5cm soda-lime glase by spin-coating at 1000rpm and was dried with air. After ten minute pre-baking at 100°C, baking was performed at 550°C for 30 minutes, and thus a transparent thin film was obtained.

### Example 42

First, 150g of ion exchanged water were fed into a 300ml four-necked flask, and 3.82g of nitrilotriacetic acid and 3.42g of copper chloride dihydrate were added thereto. The mixture was heated and stirred at 80°C. These materials were dissolved once, but thereafter, crystals precipitated. After cooling, the crystals were filtered, washed with ethanol and dried, and thus 4.12g of copper complex was obtained.

Then, 2.7g of the copper complex were dispersed in 13g of methanol and 1.3g of di-n-butylamine were added. The mixture was stirred at a reflux temperature for 30 minutes, and thus a blue transparent liquid (a composition of the present invention) was obtained. The content of copper compound in terms of copper oxide was 4.5%.

The obtained blue transparent liquid was diluted with dehydrate ethanol by a factor of 2. When coating, drying, and baking were performed under the same conditions as in Example 39, a red copper-colored transparent thin film was obtained.

### Example 43

First, 1.35g of nitrilotriacetic acid - copper complex and 14g of n-propanol were placed in a 50ml conical flask, and 1.3g of di-n-butylamine were added thereto. The mixture was stirred at 80°C for 30 minutes, and thus a blue transparent liquid (a composition of the present invention) was obtained. The content of copper compound in terms of copper oxide was 2.3%.

The obtained blue transparent liquid was applied, dried and baked in the same manner as in Example 40, and thus a red copper-colored transparent thin film was obtained.

### Example 44

First, 6.6g of tin chloride (II) dihydrate (a purity of 97%) were suspended in 17g of ion exchanged water. Then, 100g of ion exchanged water were fed into a 300ml four-necked flask, and heated to 75°C. Then, 4.78g of nitrilotriacetic acid were placed therein and the tin chloride suspension was added thereto under stirring. As the tin chloride suspension was added, the reaction liquid became transparent, but soon the tin complex started to precipitate. After one hour stirring, the reaction liquid was cooled to 10°C or less. The tin complex was filtered for collection, washed with ethanol, and dried under reduced pressure. The yield was 7.37g.

Then, 1.54g of the obtained tin complex and 20g of dehydrated ethanol were fed into a 50ml conical flask, and 0.71g of di-n-butylamine were added thereto, and a three hour reflux was performed under stirring. A trace amount of undissolved substance was left and was cooled and filtered, and thus a pale dark reddish-brown transparent liquid (a composition of the present invention) was obtained. The content of tin compound in terms of tin oxide was 3.0%.

The composition of the present invention was diluted with dehydrate ethanol by a factor of 2, and the diluted composition was applied onto a 5cm × 5cm soda-lime glass plate by spin-coating at 500rpm and was dried with air. After pre-baking at 100°C for 10 minutes, baking was performed at 550 °C for 30 minutes. Thus, a colorless transparent thin film was obtained.

### Example 45

First, 36g of dehydrated ethanol and 4.59g of nitrilotriacetic acid were fed into a 100ml four-necked flask, and 4.41g of di-n-propoxy zinc were added thereto under stirring, and 3.49g of di-n-butylamine were dripped. A four hour reflux was performed under heating conditions. A slight amount of undissolved substance was left and cooled to 10°C or less. After filtering, a pale yellow transparent liquid (a composition of the present invention) was obtained. The content of zinc compound in terms of zinc oxide was about 4.0%.

The composition of the present invention was diluted with dehydrate ethanol by a factor of 2, and the diluted composition was applied onto a 5cm × 5cm soda-lime glass plate by spin-coating at 1000rpm and was dried with air. After pre-baking at 100°C for 10 minutes, baking was performed at 550 °C for 30 minutes. Thus, a colorless transparent thin film was obtained.

### Comparative Example 1

First, 60g of dehydrated ethanol and 5.26g of ethylenediaminetetraacetic acid were fed into a 100ml four-necked flask, and 5.12g of titanium tetraisopropoxide were dripped under stirring. Then, 2.59g of di-n-butylamine were dripped and reacted therewith at a reflux temperature for one hour, and thus a transparent liquid was obtained. The liquid was cooled to 30°C, and 2.27g of 30% hydrogen peroxide solution were dripped thereto. After one hour reflux, when the mixture was cooled, crystals precipitated. The content of titanium compound in terms of titanium oxide was 1.9%.

### Comparative Example 2

First, 56g of dehydrated ethanol and 5.51g of 1,3-propane diamine tetraacetic acid were fed into a 100ml four-necked flask, and 5.12g of titanium tetraisopropoxide were dripped under stirring. Then, 2.59g of di-n-butylamine were dripped and reacted therewith at a reflux temperature for four hours, but a large amount of undissolved substance was left. The mixture was cooled to 30°C, and 2.27g of 30% hydrogen peroxide solution were dripped thereto, followed by further four hour reflux. However, a large amount of undissolved substance was left. In this case, the content of titanium compound in terms of titanium oxide was 2.0%.

### Comparative Example 3

First, 35g of ion exchanged water, 6g of ethylenediaminetetraacetic acid, 5.56g of lead chloride, 10.34g of di-n-butylamine were fed into a 100ml conical flask, and heated and stirred at 80°C for one hour. Although the reaction liquid became transparent once, soon a large amount of crystal precipitated. Further six hour heating continued, but the crystal was not dissolved at all, and a transparent liquid was not obtained.

The results of Comparative Examples 1, 2 and 3 are from the cases where ligands having 6 or more coordination were used. Compared with Examples 1 (Ti) and Example 41 (Pb) using ligands having 5 or less coordination, the metal salt cannot be contained in a high concentration.

### Example 46

First, 250g of ion exchanged water were fed into a 500ml four-necked flask, and 6.50g of nitrilotriacetic acid and 8.82g of bismuth carbonate were added thereto. The mixture was heated and stirred at 80°C. The precipitated crystal was filtered and 100g of ethanol were added to the filtrate under stirring. After cooling, the precipitated crystals were filtered for collection, washed with ethanol and dried, and thus 2.01g of bismuth complex was obtained.

Then, 1.0g of the nitrilotriacetic acid - bismuth complex and 5.90g of ethanol were placed in a 50ml conical flask, and 0.4g of di-n-butylamine were added. The mixture was stirred at a reflux temperature for one hour, and thus a slightly white solution (a composition of the present invention) was obtained. The content of bismuth compounds in terms of bismuth oxide was 8.0%.

An ethanol solution of the obtained bismuth complex and an ethanol solution of the titanium complex obtained in Example 2 were mixed such that the ratio of titanium to bismuth was 3:4, and thus a coating solution was obtained. There was no abnormality caused by the mixing. This coating solution was applied onto a 5cm × 5cm borosilicate glass plate by spin-coating at 1000rpm, and was pre-baked at 100°C for ten minutes, followed by 30 minutes baking at 550°C. Then, a transparent thin film was obtained.

### Example 47

The ethanol solution of a salt of a titanium complex and di-n-butylamine obtained in Example 1, the ethanol solution of a salt of the zirconium complex and di-n-butylamine obtained in Example 20, and the ethanol solution of a salt of the lead salt complex and di-n-butylamine obtained in Example 41 were weighed exactly such that the ratio of Pb:Zr:Ti was 1:0.52:0.48, and mixed in the order of Zr, Ti and Pb. No precipitation or no suspension of crystals was observed in the mixed solution. Furthermore, the state of the solution was not changed after the solution was allowed to stand over night at room temperature.

Then, 3.78g of ethanol was added to 4.00g of the obtained mixed solution, and this mixture was applied onto a substrate of a platinum plate by flow coating. Then, this was baked at 500°C, 600 °C and 700 °C each for 30 minutes. The nature of the produced thin film was measured by X-ray diffraction. The measurement was performed with 0.5° as the incident angle for platinum. Figure 2 shows the results in the case where baking was performed at 700°C in the air.

Although not shown in the drawings, when the baking temperature is 500°C, only the peaks indicating an amorphous state were observed. When the baking temperature is 600°C, the peaks indicating crystallization were observed, and the peaks of the perovskite structure of lead zirconate titanate (not shown) were observed. On the other hand, as seen from Figure 2, when the baking temperature was 700°C, complete crystallization was established, and the peaks supporting the perovskite structure of lead zirconate titanate were observed. In other words, the peaks of 22.4°, 31.5°, 38.7°, 44.9°, 50.8°, 56.2°, 65.2°, and 75.2° for 2 correspond to the data described for PbZrₓTi₁₋ₓO₃ (x=0.52) of No.330784 of the JCPDS card.

In the Figure 2, ○ indicates the peaks of the perovskite structure, and indicates the peaks derived from platinum used as the substrate. The results indicate that the composite metal oxide thin film of lead zirconate titanate can be used as a ferroelectric substance.

### Example 48

The ethanol solution (the content of titanium compound in terms of titanium oxide of 8.0%) containing the salt of the titanium complex and n-butylamine produced with nitrilotriacetic acid prepared in Example 2 was diluted with dehydrated ethanol by a factor of 2 so that the content of titanium compound in terms of titanium oxide was 4.0%. This diluted liquid was applied onto a 5cm × 5cm non-alkali glass by spin-coating at 1000rpm. After pre-baking at 100°C for 10 minutes, baking was performed at 550 °C for 30 minutes. Then, a uniform transparent thin film was obtained. The thickness of this thin film that was measured with a trailing-stylus surface shape measuring instrument was 140nm.

On the other hand, the ethanol solution (the content of titanium compound in terms of titanium oxide of 1.9%) containing the salt of the titanium complex and di-n-butylamine produced with ethylenediaminetetraacetic acid obtained in Comparative Example 1 was applied onto a 5cm × 5cm non-alkali glass by spin-coating at 1000rpm in the same manner as in Example 48. After pre-baking at 100°C for 10 minutes, baking was performed at 550 °C for 30 minutes. Then, a uniform transparent thin film was obtained. However, the thickness of this thin film was only 50nm.

This indicates that the composition of the present invention can provide a comparatively thick film by one film-forming process.

### Industrial Applicability

The composition of the present invention containing a salt of an amine and a metal complex formed of a ligand having 5 or less coordination and a metal compound can contain metal oxide in a high concentration, compared with a conventional composition containing a salt of a metal complex formed of a ligand having 6 or more coordination and a metal compound and amine. For example, when the content of titanium compound in terms of titanium oxide was 1.9% in the conventional composition, crystals precipitated, whereas there was no precipitation even when the content of titanium compound in terms of titanium oxide was 8% in the composition of the present invention. In the composition of the present invention, no precipitation occurred even if it was stored at room temperature for 2 months.

The present invention provides a composition for forming a metal oxide thin film that can contain metal oxide in a high concentration. The metal oxide can be contained in a high concentration, so that a comparatively thick film can be obtained in one film-forming process. Therefore the present invention is advantageous in terms of production process, and the cost to transport the composition for thin films can be reduced significantly.

Furthermore, the ligand having a 5 or less coordination used in the present invention has excellent biodegradability, so that environmental pollution in the production process can be reduced.

## Claims

1. A composition for forming a metal oxide thin film comprising a salt of an amine and a metal complex or a salt of a metal compound formed of a ligand having 5 or less coordination and a metal compound.

2. The composition for forming a metal oxide thin film according to claim 1, wherein ionic dioxide are coordinated in the metal.

3. The composition for forming a metal oxide thin film according to claim 1 or 2, wherein the salt is dissolved in a polar solvent.

4. The composition for forming a metal oxide thin film according to any one of claims 1 to 3, wherein the ligand having 5 or less coordination is an amino polycarboxylic acid, a hydroxycarboxylic acid or an amino acid.

5. The composition for forming a metal oxide thin film according to any one of claims 1 to 4, wherein the amine is an aliphatic amine or an aromatic amine having 12 or less carbon atoms.

6. The composition for forming a metal oxide thin film according to any one of claims 1 to 5, wherein the salt of an amine and a metal complex or a metal salt is a salt of an amine and a complex or a salt of titanium, bismuth, barium, zirconium, magnesium, lead, copper, tin, zinc, indium, or strontium, or a combination of two or more of these.

7. The composition for forming a metal oxide thin film according to claim 6, wherein the composition for forming a metal oxide thin film is a composition for a composite metal oxide comprising titanium, and contains a salt of a titanium complex and an amine and a salt of other metal complex and an amine.

8. The composition for forming a metal oxide thin film according to claim 7, wherein the composition for forming a metal oxide thin film is a composition for bismuth titanate composite metal oxide, and contains a salt of a titanium complex and an amine and a salt of a bismuth complex and an amine.

9. The composition for forming a metal oxide thin film according to claim 7, wherein the composition for forming a metal oxide thin film is a composition for barium titanate composite metal oxide, and contains a salt of a titanium complex and an amine and a salt of a barium salt and an amine.

10. The composition for forming a metal oxide thin film according to claim 7, wherein the composition for forming a metal oxide thin film is a composition for lead zirconate titanate composite metal oxide, and contains a salt of a titanium complex and an amine, a salt of a zirconium complex and an amine, and a salt of a lead salt and an amine.

11. A method for manufacturing a composition for forming a metal oxide thin film including the step of reacting a metal compound, a ligand having 5 or less coordination, and an amine.

12. The method according to claim 11, wherein the method further includes the step of treating with an oxidizer after the above step.

13. The method according to claim 11 or 12, wherein the metal compound is metal alkoxide.
